# FASCICULE DE BREVET EUROPEEN

(11) **EP 0 477 766 B1**
(45) Date de publication et mention de la délivrance du brevet: **22.05.1996**
(21) Numéro de dépôt: 91115894.7
(22) Date de dépôt: 19.09.1991
(51) Int. Cl.: H05K 3/00

(54) **Machine-outil, notamment pour l'usinage de plaques de circuits imprimés**
Werkzeugmaschine, insbesondere zur Bearbeitung von gedruckten Schaltungsplatten
Machine tool, in particular for working printed circuit boards

(30) Priorité: 28.09.1990 FR 9012093
(43) Date de publication de la demande: 01.04.1992
(73) Titulaire: POSALUX SA, CH-2504 Bienne (CH)
(72) Inventeur: Christen, Erich, CH-3294 Bueren (CH); Lautenschlager, Pierre-André, CH-2515 Prêles (CH)
(74) Mandataire: Caron, Gérard

(56) Documents cités:
- DE-A- 3 615 888
- DE-A- 3 719 167
- FR-A- 2 532 226
- US-A- 4 654 956
- US-A- 4 786 216
- IBM TECHNICAL DISCLOSURE BULLETIN, vol. 31, no. 11, Avril 1989, NEW YORK US pages 242 - 243; 'Gridless printed circuit board drilling machine'
- FEINWERKTECHNIK + MESSTECHNIK, vol. 94, no. 5, Mai 1986, DE pages 52 - 60; E. CHRISTEN: 'Rationelles Bohren in Leiterplatten'
- IBM TECHNICAL DISCLOSURE BULLETIN, vol. 33, no. 1A, Juin 1990, NEW YORK US pages 485 - 487; 'method for beveling edges of populated printed wiring boards and beveling machine'

## Description

La présente invention concerne les machines-outils et, plus particulièrement, les machines-outils destinées à réaliser des opérations d'usinage, en particulier mécanique, par enlèvement de copeaux sur des matériaux en plaques de plus ou moins grande épaisseur. Plus particulièrement, l'invention est relative à des machines-outils capable d'exécuter automatiquement des opérations de perçage, de contournage ou de fraisage sur des plaques ou empilements de plaques de circuits imprimés.

On connaît du brevet français FR 2 616 615 une machine à commande numérique pour l'usinage de plaques de circuits imprimés. Cette machine comprend essentiellement une table porte-pièce qui est mobile dans une première direction, notamment selon un axe Y, et une pluralité d'unités de travail dans chacune desquelles se trouve une broche motorisée destinée à recevoir un outil rotatif pour l'exécution d'une opération d'usinage donnée.

Ces unités de travail sont reliées rigidement à un chariot qui est mobile dans une deuxième direction perpendiculaire à la première, notamment selon un axe X. Par ailleurs, les unités de travail sont mobiles simultanément ou indépendamment dans une troisième direction perpendiculaire aux deux autres, notamment selon un axe Z.

Les unités de travail sont montées sur leur chariot commun avec un entre-axe fixe qui est légèrement supérieur à la largeur maximale des circuits imprimés à usiner, largeur qui est d'ailleurs égale à la course maximale selon l'axe X du chariot qui porte les unités de travail.

Comme ainsi celles-ci se déplacent nécessairement de concert selon l'axe X, leur position par rapport aux plaques à usiner est la même pour toutes lors de chaque opération d'usinage individuelle. Il en résulte que l'on ne peut exécuter que le même motif d'usinage (une répartion uniforme de trous par exemple, s'il s'agit d'un perçage) sur toutes les plaques en même temps à moins de décaler dans le temps les opérations d'usinage exécutées sur les différentes plaques. Cependant, si on opte pour cette solution, on réduit évidemment l'efficacité de la machine, car on ne pourra pas toujours travailler simultanément sur toutes les plaques.

Si, par ailleurs, on souhaite usiner des plaques de circuits imprimés ayant des dimensions supérieures à l'entre-axe des unités de travail, la mise en oeuvre simultanée de toutes les unités de travail devient impossible, en raison du débordement des plaques de circuits imprimés par rapport à la surface balayable des unités de travail voisines, si bien que l'on diminue, dans ce cas également, considérablement la capacité de production de la machine.

Si, enfin, on cherche à usiner des plaques de circuits imprimés ayant des dimensions inférieures à l'entre-axe des unités de travail, toute la surface disponible, balayable par chaque unité de travail n'est pas utilisée si bien que là encore, la machine n'est pas exploitée au mieux de ses capacités potentielles.

Or, la tendance actuelle dans l'usinage et en particulier dans le perçage, le contournage et le fraisage de plaques de circuits imprimés est de pouvoir usiner le plus rapidement possible des séries de formats différents sur une même machine, voire de mélanger dans un même chargement de plaques à usiner, plusieurs formats différents de plaques nécessitant des motifs d'usinage également différents. Le problème qui est à la base de la présente invention consiste donc à satisfaire ce besoin de l'industrie des circuits imprimés.

Il est à noter que dans le brevet FR 2 532 226, on décrit une machine-outil dans lequel l'entre-axe des unités de travail est réglable au préalable c'est-à-dire une fois pour toutes avant que l'on démarre la machine pour l'exécution d'un travail donné. Cependant, il est évident que ce mode de montage qui conduit à un entre-axe statique ne peut contribuer à résoudre le problème posé qui est à la base de la présente invention, puisqu'il nécessite de fréquentes interventions d'un spécialiste qui doit réaliser différentes opérations de montage telles que vissage, réglage précis etc. pour obtenir le nouvel entre-axe entre les unités de travail.

Le document IBM Technical Disclosure Bulletin, vol. 31, no. 11, Avril 1989, New York, US, pages 242-243, décrit l'ensemble des caractéristiques du préambule de la revendication 1.

L'invention a pour but de fournir une machine-outil notamment pour l'usinage de plaques de circuits imprimés, capable de travailler sur des plaques de dimensions quelconques, pouvant être différentes pour les diverses unités de travail que comporte la machine, l'usinage pouvant être exécuté toujours avec une efficacité et une rapidité maximales en fonction des divers paramètres d'usinage souhaités.

L'invention a donc pour objet une machine-outil, notamment pour l'usinage de circuits imprimés par perçage, fraisage ou contournage, cette machine comprenant :
- un bâti,
- un porte-pièces monté mobile sur ledit bâti dans au moins une première direction,
- des premiers moyens moteurs destinés à déplacer le porte-pièces,
- au moins deux unités de travail aptes à recevoir sélectivement des outils pour exécuter lesdites opérations d'usinage,
- des moyens de guidage solidaires dudit bâti pour guider lesdites unités de travail dans une seconde direction perpendiculaire à ladite première direction,
- des moyens de coulissement coopérant avec lesdits moyens de guidage et portant lesdites unités de travail pour permettre de les déplacer selon ladite seconde direction, et
- des seconds moyens moteurs couplés auxdits moyens de coulissement pour assurer les déplacements desdites unités de travail,
cette machine-outil étant caractérisée en ce que
- lesdits moyens de coulissement comportent des unités de coulissement indépendantes associées à chaque unité de travail respective et en ce que
- lesdits seconds moyens moteurs comportent une unité motrice et des moyens de commande de l'unité motrice pour chaque unité de travail afin de déplacer de façon complètement indépendante chacune des unités de travail dans ladite deuxième direction.

Il résulte de ces caractéristiques que l'entre-axe des unités de travail peut être ajusté dynamiquement pendant les opérations d'usinage ce dont il résulte une souplesse d'utilisation tout-à-fait remarquable. En effet, de cette manière, on peut travailler avec des dimensions de plaques de circuits absolument quelconques, leur étendue dans la seconde direction pouvant être choisie à volonté (dans les limites de largeur de la machine elle-même, bien entendu).

De la sorte, si par exemple, on veut travailler sur une plaque dont la dimension latérale (c'est-à-dire selon la seconde direction) dépasse l'entre-axe de deux unités adjacentes, on peut faire travailler ces unités simultanément sur cette même plaque, puisque le motif de "balayage" de la plaque par chaque unité de travail pourra être choisi et commandé de façon totalement indépendante des motifs des autres unités.

Si, au contraire, on souhaite travailler sur des plaques de faible étendue latérale, ou sur des plaques qui à terme seront totalement différentes les unes des autres, on peut commander les unités sans qu'elles doivent s'attendre mutuellement pour exécuter leur travail.

Cependant, rien n'empêche dans la machine suivant l'invention, de travailler selon le principe classique de couplage rigide des mouvements des unités de travail. Il suffit, là encore, de commander leurs mouvements en conséquence.

Selon une autre caractéristique avantageuse de l'invention, les unités de coulissement associées à chaque unité de travail débordent latéralement d'un carter abritant l'unité de travail, le carter étant conçu de manière à ménager des espaces d'effacement dans lesquels les unités de coulissement des unités de travail adjacentes peuvent être imbriquées.

On obtient ainsi un entre-axe entre les unités de travail adjacentes qui peut être réduit à une valeur inférieure à la dimension modulaire habituellement utilisée dans la technique des circuits imprimés, dimension modulaire qui vaut actuellement 6 pouces (154 mm, environ). Ainsi, la machine permet de travailler simultanément sur plusieurs circuits ayant cette dimension modulaire minimale.

D'autres caractéristiques de l'invention apparaîtront mieux à la lecture de la description détaillée qui suit, faite en référence aux dessins annexés qui sont donnés uniquement à titre d'exemple et dans lesquels :
- la figure 1 représente une vue frontale en perspective d'une machine-outil suivant l'invention;
- la figure 2 est une vue en plan de la table porte-pièces de cette machine, montée sur un bâti;
- la figure 3 est une vue en perspective, à plus grande échelle, d'une partie de la machine mettant en évidence notamment la sustentation des ses unités de travail;
- la figure 4 est une vue en élévation, à une échelle encore plus grande et partiellement en coupe, d'une unité de travail, la figure montrant en particulier le mode de sustentation de cette unité de travail;
- la figure 5 est une vue en élévation de quatre unités de travail et de leurs moyens de coulissement;
- la figure 6 est une vue, à la même échelle que la figure 4, d'une unité de travail, la figure montrant par une coupe partielle les moyens moteurs permettant d'entraîner cette unité de travail et
- la figure 7 est une vue à grande échelle d'un magasin d'outils et de ses dispositifs de transfert associés, appartenant à chaque unité de travail de la machine.

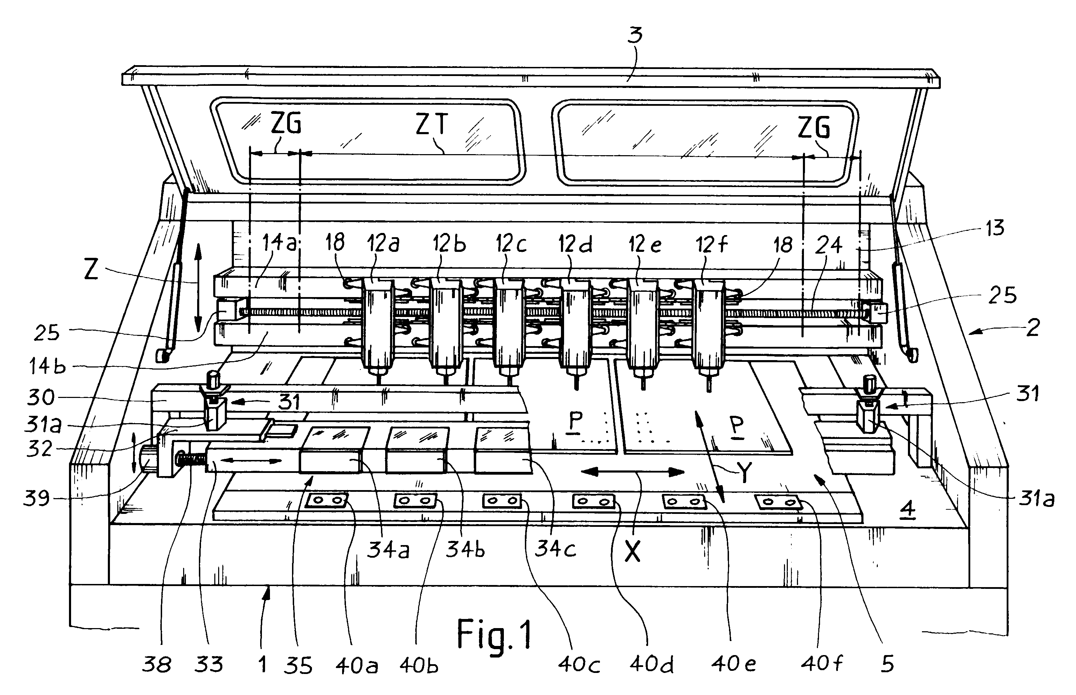

La figure 1 montre une vue générale de la machine-outil suivant l'invention qui comprend un bâti 1 surmonté d'un carter 2 muni d'un couvercle 3 qui peut être placé en position ouverte afin de donner accès aux organes essentiels de la machine.

Le bâti 1 définit une surface de travail 4 sur laquelle peut se déplacer une table porte-pièces 5 dans une direction orientée d'avant en arrière, cette direction étant appelée Y (c'est-à-dire la première direction) dans la suite de la description.

Il est à noter que la direction horizontale (c'est-à-dire la seconde direction) perpendiculaire à la direction Y sera appelée direction X, la direction verticale étant appelée direction Z.

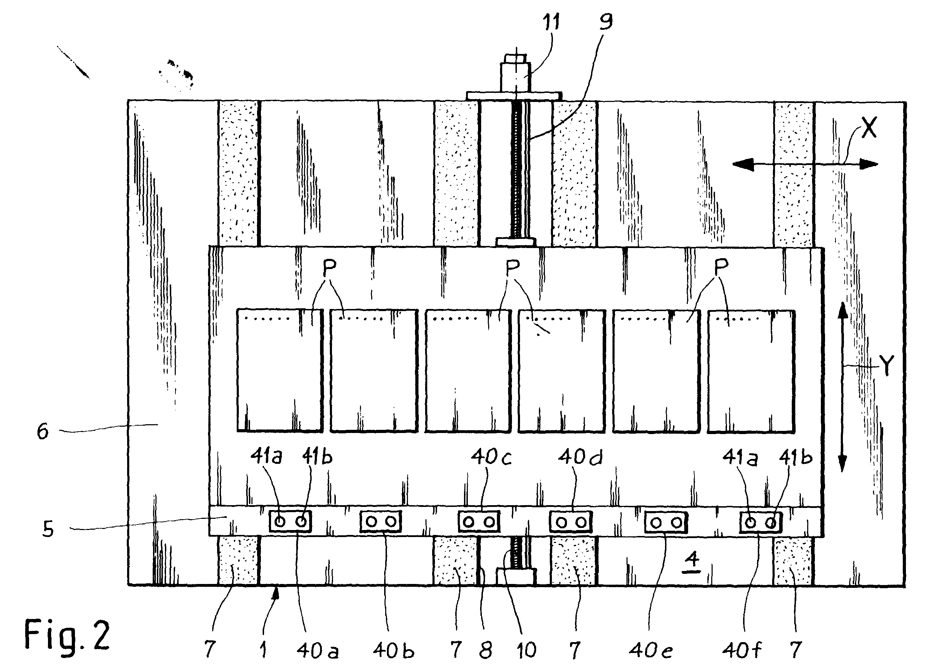

La figure 2 montre schématiquement que le bâti 1 est formé d'un bloc massif 6, en béton aux polymères par exemple, dans lequel sont disposés, parallèlement à la direction Y, plusieurs chemins de coulissement 7 dont les surfaces supérieures affleurent la surface de travail 4 et qui peuvent être réalisées aux moyens de barreaux en granit. Une rainure centrale 8 est ménagée au centre de la surface de travail 4 dans la direction Y. Elle reçoit une règle de positionnement 9 coopérant avec un capteur, photo-électrique par exemple, (non représenté) permettant de placer la table 5 avec précision à un endroit quelconque selon la direction Y. Une vis sans fin 10 coopère avec une noix de déplacement (également non représentée) solidaire de la table, la vis sans fin étant entraînée par un moteur 11.

Par ailleurs, la table porte-pièces 5 est équipée de moyens (connus en soi et non-représentés) destinés à assurer la fixation des pièces à usiner, qui dans le cas décrit ici, sont constituées par des plaques de circuits imprimés P ou des empilements de telles plaques.

Les figures 1, 3 et 4 montrent plus particulièrement que la machine suivant l'invention comporte des unités de travail 12 (référencées 12a à 12f sur la figure 1) qui sont montées mobiles selon la direction X. A cet effet, le bâti 1 comporte un support vertical 13 en forme de C et portant des poutres de sustentation 14a et 14b servant de coulisses aux unités de travail 12a à 12f.

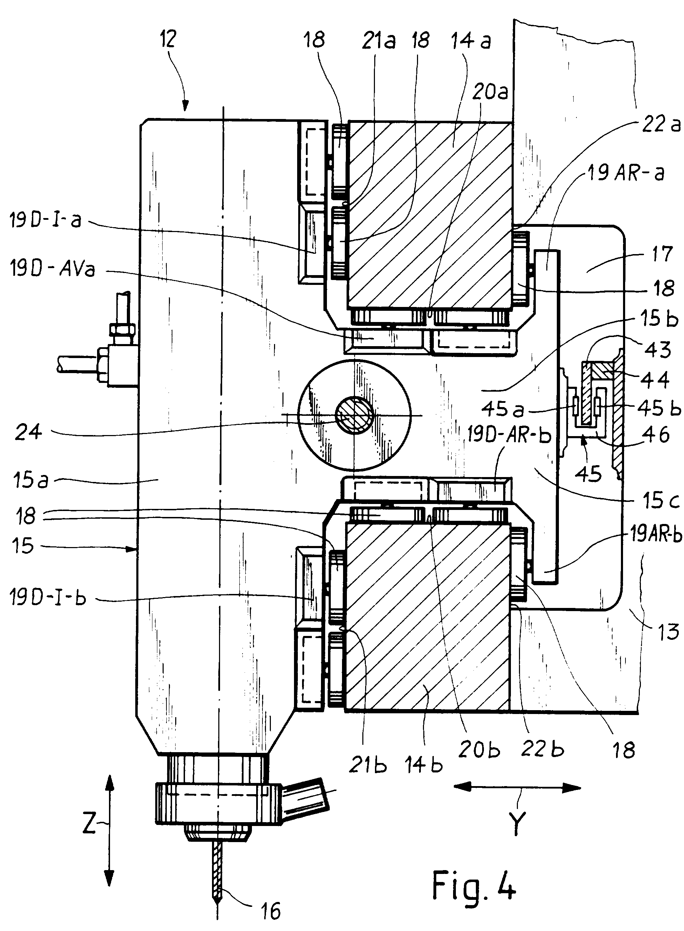

Les unités de travail, qui sont ici au nombre de six, mais dont le nombre peut être plus au moins grand suivant la taille de la machine, comportent chacune une broche (non représentée) logée dans un carter 15 dont la forme générale (voir figure 4) ressemble à un H. Chaque broche dont la construction est connue en soi, est destinée à entraîner en rotation à haute vitesse un outil 16 qui peut être un foret, une fraise ou tout autre outil devant être utilisé pour travailler sur les pièces à usiner. La broche peut se déplacer verticalement pour l'exécution d'un perçage, par exemple.

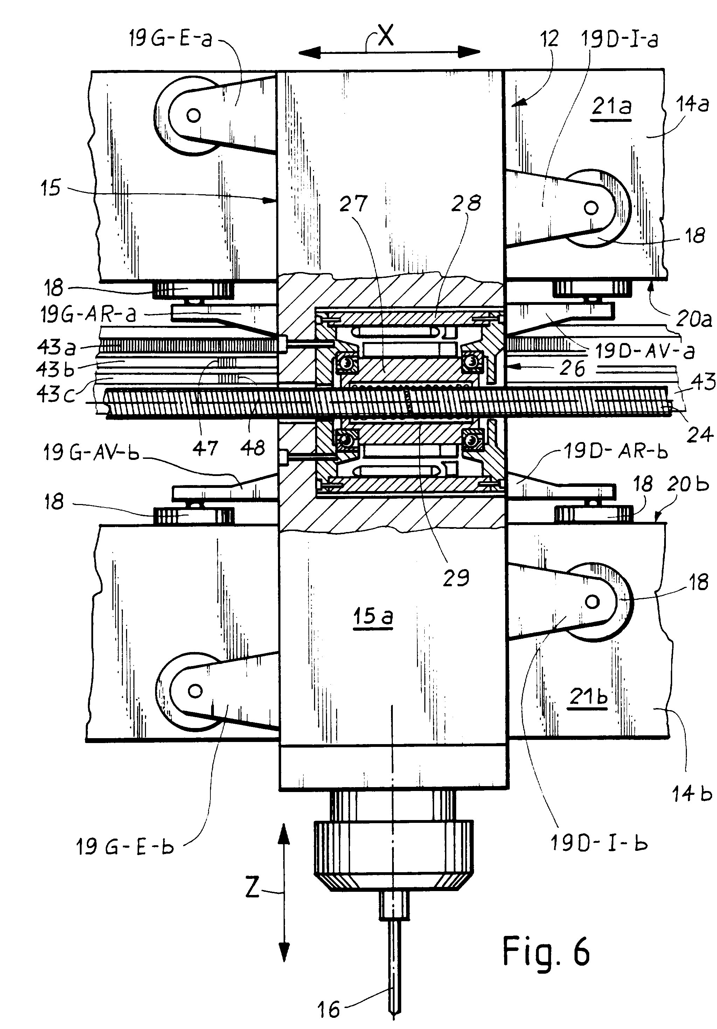

Les figures 4 et 6 montrent que le carter 15 de chaque unité de travail comportent une partie avant 15a de section horizontale à peu près rectangulaire d'où s'étend vers l'arrière un bras de support 15b qui se termine à son tour par une plaque verticale 15c dont les bords sont situés dans un couloir arrière 17 s'étendant horizontalement dans la direction X. Ce couloir 17 est délimité par le support 13 et les poutres de sustentation 14a et 14b, comme cela est clairement représenté à la figure 4.

Le carter 15 de chaque broche présente en outre plusieurs pattes de sustentation à l'extrémité desquelles sont prévues des patins 18 auxquelles est appliqué de l'air sous pression permettant de créer entre le patin respectif et les poutres de sustentation 14a et 14b un coussin d'air éliminant les frottements au cours des mouvements de l'unité de travail. Il est à noter que des patins identiques (non représentés) sont utilisés pour la sustentation de la table porte-pièces 5 au-dessus des chemins de glissement 7 (figure 2).

Les pattes de sustentation sont réparties de la façon suivante :
- quatre pattes horizontales, deux à gauche (figure 6) référencées 19G-AR-a et 19G-AV-b et deux à droite référencées 19D-AV-a et 19D-AR-b. Les patins 18 de ces pattes sont en appui contre les faces horizontales respectives 20a et 20b des poutres 14a et 14b,
- quatre pattes verticales avant, et plus précisément deux pattes à gauche et externes 19G-E-a et 19G-E-b et deux pattes à droite et internes à savoir 19D-I-a et 19D-I-b. Les patins 18 de ces pattes sont en appui respectivement contre les faces avant 21a et 21b des poutres 14a et 14b,
- quatre pattes verticales arrière dont deux (19-AR-a) sont en appui contre la face verticale arrière 22a de la poutre 14a et dont les deux autres (19 AR-b) sont en appui contre la face verticale arrière 22b de la poutre 14b. En fait, ces pattes sont matérialisées par les zones d'angle de la plaque arrière 15c du carter 15 de chaque unité de travail 12.

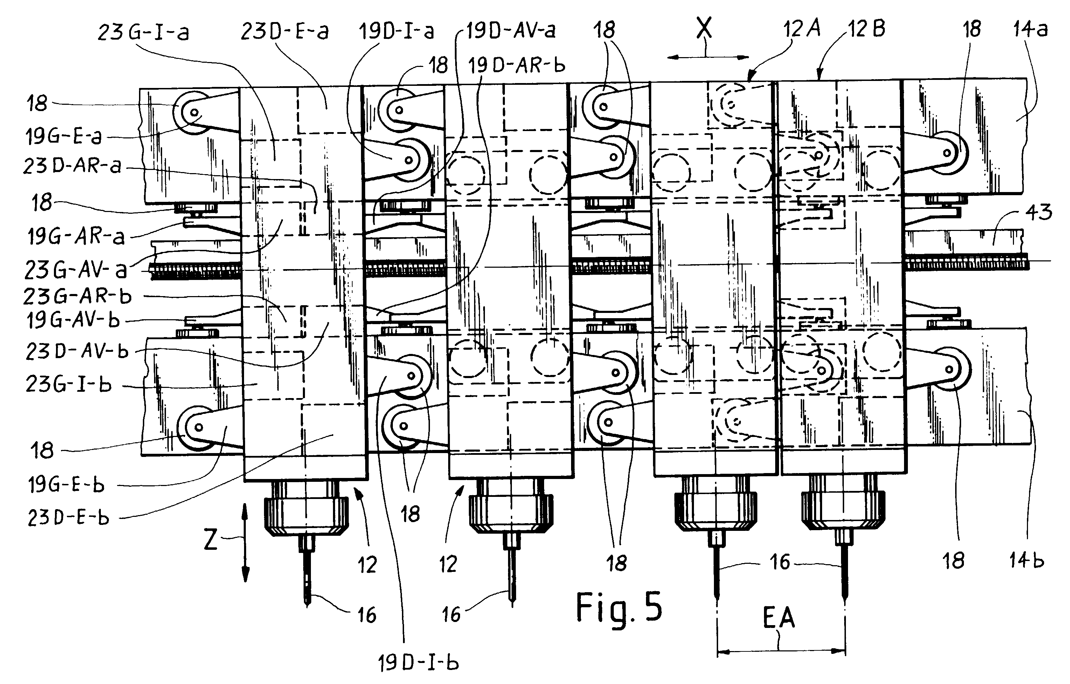

On notera que le carter 15 est conformé de manière à pouvoir abriter les pattes de sustentation des unités de travail voisines lorsque celles-ci sont rapprochées au maximum les unes des autres, comme cela est représenté à droite de la figure 5. Ces dégagements ne sont pas nécessaires pour les patins 18 qui se trouvent appliqués contre les faces arrière 22a et 22b des poutres 14a et 14b, puisque ces patins s'inscrivent dans le périmètre de la face arrière du boîtier parallélépipédique que constitue le carter 15.

Ainsi, chaque unité de travail comporte les dégagements suivants : (figure 5)
- quatre dégagements horizontaux référencés 23G-AV-a, 23D-AR-a, 23G-AR-b et 23D-AV-b, et
- quatre dégagements verticaux référencés 23G-I-a, 23D-E-a, 23G-I-b et 23D-E-b.

En considérant la moitié droite de la figure 5, on constate que, grâce à la forme particulière des carters 15, les pattes de sustentation s'imbriquent dans les unités de travail adjacentes, tout en garantissant néanmoins une très bonne stabilité spatiale des unités grâce à un éloignement maximal de leurs points de sustentation.

Il en résulte que l'entre-axe EA des outils 16 de deux unités de travail contigües (12A et 12B, par exemple sur la figure 5) peut être réduit au minimum c'est-à-dire pratiquement à une valeur légèrement inférieure au module minimal normalisé des cartes de circuits imprimés (actuellement de six pouces ou 154 mm).

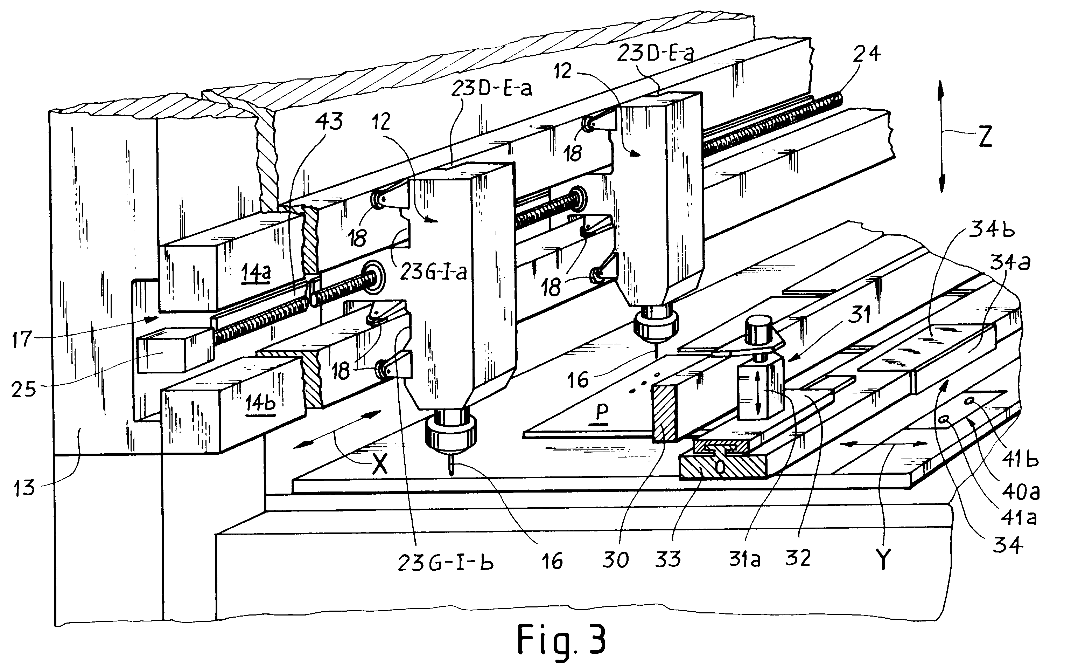

Les figures 3 et 6 montrent également que, selon une caractéristique particulièrement avantageuse de l'invention, les unités de travail coopérent toutes avec un même organe de réaction qui est ici une même vis sans fin 24 du type "vis à billes" qui s'étend horizontalement au moins sur toute la largeur de la zone de travail de la machine entre les poutres 14a et 14b, tout en étant montée fixe dans des consoles d'extrémité 25 solidaires du support vertical 13. Chaque unité de travail 12 comporte son propre moteur d'entraînement 26 avec un rotor 27 et un stator 28, le rotor étant en prise par un alésage intérieur 29 équipé de billes avec la vis 24, tandis que le stator 28 est monté fixe dans le carter 15 de l'unité de travail. Le moteur est réalisé, de préférence, sous la forme d'un moteur électrique.

Comme chaque moteur peut être excité individuellement, le déplacement selon la direction X des unités de travail est complètement indépendant, leur écartement mutuel pouvant être variable de façon dynamique en fonction du programme d'usinage à exécuter.

Dans le mode de réalisation décrit, la vis 24 dépasse avantageusement la largeur de la zone de travail ZT de la machine permettant ainsi d'écarter une ou plusieurs unités sur le côté dans des zones de garage ZG lorsque le programme de travail les rend inutiles temporairement (figure 1). Bien entendu, une telle zone peut être prévue soit des deux côtés, soit d'un seul côté seulement de la machine.

L'invention ne se limite pas au dispositif d'entraînement des unités que l'on vient de décrire. Ainsi, il est possible d'utiliser un autre organe de réaction que la vis 24 et un autre genre de dispositif moteur équipant chaque unité, l'essentiel étant que la force motrice est engendrée dans l'unité elle-même et "appuie" sur un organe de réaction commun à toutes les unités.

Cependant, au prix de renoncer à cet avantage particulier, l'invention s'étend également à des constructions dans lesquelles l'indépendance des mouvements de unités de travail pourrait être assurée par des dispositifs moteurs eux-mêmes totalement indépendants les uns des autres et comportant donc un organe de réaction propre à chaque unité de travail.

En ce qui concerne les mouvements individuels dans la direction X des unités de travail 12a à 12f, la machine est équipée d'un système de positionnement incrémental linéaire, permettant de positionner les unités dans la direction X, non seulement par rapport à la table 5, mais également les unes par rapport aux autres.

Ce système comporte notamment une règle de mesure incrémentale 43 qui est montée fixe sur le support vertical 13 dans le couloir arrière 17. Elle s'étend parallélement à la vis 24 et a la même longueur que celle-ci.

Sur la figure 4, on voit que la règle 43 est fixée sur des potences 44 prévue de distance en distance dans le couloir 17. Elle est transparente et coopère avec un capteur photo-électrique 45 monté sur chaque unité de travail 12a à 12f. De façon connue en soi, le capteur comporte un étrier 46 dans les branches desquelles sont respectivement prévues une source lumineuse 45a et une cellule photo-électrique 45b.

La règle 43 présente (figure 6) une première graduation 43a formée par des traits régulièrement espacés sur toute la longueur de la règle. Cette graduation permet un positionnement précis des unités de travail par rapport à leurs positions de repos prédéterminées également fixées par la règle 43. A cet effet, celle-ci présente une deuxième graduation 43b formée d'autant de repères de position de repos 47 qu'il y a d'unités de travail. Dans le cas de la machine décrite, il y a donc six repères de position 47 espacés régulièrement les uns des autres le long de la règle 43. Une troisième graduation 43c affecte, par un code matérialisé en 48, un numéro d'ordre à chaque repère 47 propre à l'unité de travail correspondant à cette position de repos. Les unités de travail sont amenées systèmatiquement à leur position de repos, au démarrage de la machine.

On constate donc que, selon une caractéristique importante de l'invention, le positionnement des unités de travail selon la direction X est rapporté sur une seule et même règle de référence. Outre la simplicité de construction, ce système de positionnement présente l'avantage que chaque unité de travail peut, à partir de sa propre position de repos, être positionnée à un endroit quelconque selon la direction X, pour autant que les autres unités ne lui font pas obstacle, ce positionnement pouvant être réalisé avec une précision qui ne dépend pas de la précision de positionnement des autres unités de travail. Il en serait autrement si chaque unité de travail avait sa propre règle de positionnement indépendante de celle des autres unités. Toutefois, dans le cadre général de l'invention, une telle solution pourrait être envisagée sans perdre le bénéfice des avantages liés au positionnement indépendant et dynamique des unités de travail.

Dans le mode de réalisation décrit, la machine est également équipée d'un dispositif de changement automatique des outils 16 (figures 1, 3 et 7).

Ce dispositif comprend un portique 30 fixé à l'avant de la machine sur la surface de travail 4 et orienté selon la direction X. Sur ce portique, qui enjambe la table porte-pièces 5, sont montés des mécanismes élévateurs 31 dont les parties mobiles 31a portent des supports 32 mobiles en translation verticale selon la direction Z. Ces supports 32 forment des coulisses d'une règle 33 s'étendant parallèlement au portique 30 et mobile longitudinalement dans la direction X.

La règle 33 délimite des logements 34 (à savoir les logements 34a à 34f) pour des magasins d'outils 35 à raison d'un magasin par unité de travail 12. Selon une variante non représentée, on peut associer à chaque unité de travail deux magasins, l'un pour des outils d'un certain type et l'autre destiné à contenir des outils d'un autre type. Une telle disposition peut, dans certains cas, faciliter le travail de l'opérateur chargé de la conduite de la machine. Il serait d'ailleurs également possible de concevoir une disposition dans laquelle un seul magasin serait associé à plusieurs, voire à toutes les unités de travail en même temps.

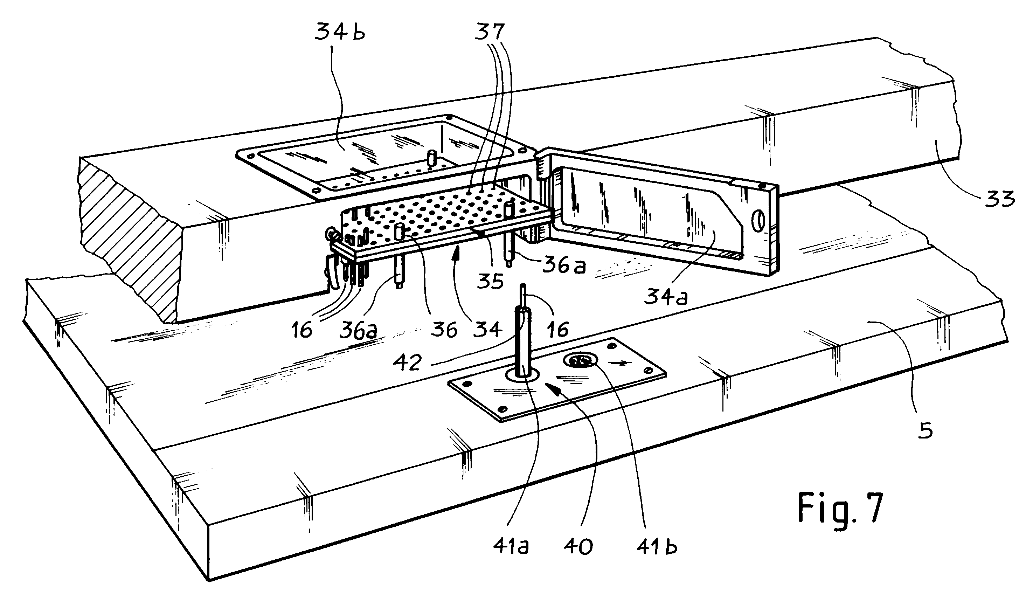

Chaque logement 34 peut être fermé par une porte 34a, et comprend un couvercle transparent fixe 34b. Les magasins d'outils sont réalisés de préférence conformément à la description qui en est donnée dans le brevet français FR-2 532 226. Ainsi, comme représenté à la figure 7, chaque magasin d'outils se présente sous la forme d'une cassette amovible montée coulissante à la façon d'un tiroir dans son logement 34 (la cassette est légèrement sortie sur la figure 7). La cassette comprend une plaque 36 dans laquelle est prévue un réseau matriciel de trous 37 destinés à recevoir chacun un outil 16 qui peut y être inséré ou en être enlevé par en-dessous lorsque la plaque 36 se trouve en place dans son logement. Un dispositif de maintien des tiges des outils (non représenté ici) est prévu dans la plaque, par exemple de la même façon que dans le brevet français FR-2 532 226 précité. Des pieds 36a permettent de poser la plaque sur une table sans déranger les outils qu'elle porte.

La figure 3 montre également que la règle 33 est couplée à une vis 38 montée rotative dans une partie verticale solidaire du support 32 qui est prévu à gauche de la machine. Cette vis est couplée à son tour à un moteur d'entraînement 39 fixé sur la plaque 32. De la sorte, la règle 33 équipée des magasins peut se déplacer selon la direction X.

Comme décrit également dans le brevet FR-2 532 226, la table porte-pièces comprend plusieurs dispositifs de transfert d'outils 40, (à raison d'un 40a à 40f par unité de travail) destinés à assurer le transport d'un outil quelconque d'un magasin vers l'unité de travail associée et vice-versa, et ce grâce aux mouvements relatifs de la table porte-pièces 5 et de la règle 33 par rapport aux unités de travail respectives.

Chaque dispositif de transfert comporte deux organes de préhension d'outils 41a, 41b de construction identique. Chacun comporte une pince 42 portée par un piston mobile verticalement selon la direction Z par un vérin par exemple (non visible sur le dessin), de manière à pouvoir s'escamoter dans la table porte-pièces 5 et à en sortir.

Sur la figure 7, l'un des organes de préhension est sorti, tandis que l'autre est escamoté. Par ailleurs, la porte 34a est normalement fermée au cours du travail de la machine.

La présence des deux organes de préhension escamotables permet de changer les outils en un temps minimal et avec un minimum de mouvements. L'un des organes peut servir pour transporter l'outil à utiliser (prélevé du magasin) tandis que l'autre peut transporter l'outil qui vient d'être utilisé (prélevé de l'unité de travail). Une partie du trajet des outils utilisés et à utiliser peut ainsi être commune.

Pour faciliter le chargement de la machine, les supports 32 auxquels est suspendue la règle 33 munie des magasins d'outils 35 peuvent être soulevées par les dispositifs élévateurs 31, moyennant quoi les plaques P, individuellement ou en empilement peuvent aisément être amenées à leur place.

Préablablement, les magasins 35 ont été remplis avec les outils qui seront à utiliser pour l,usinage des plaques. Compte tenu de leur grande capacité, les magasins peuvent pratiquement toujours contenir tous les outils nécessaires, y compris ceux qui doivent remplacer des outils usés ou éventuellement cassés. Au cours du travail, la règle 33 est abaissée.

Chaque plaque ou jeu de plaques P peut donc être usiné, selon des motifs qui peuvent être différents ou identiques au gré des besoins. Les mouvements en X, Y et Z des divers organes de la machine sont régis par un dispositif à commande numérique connu en soi, programmé convenablement et agissant sur les divers dispositifs d'entraînement de la machine à l'aide des systèmes de positionnement prévus tant pour la table 5 que pour les unités de travail 12a à 12f.

On voit donc que, grâce à l'invention, la machine peut être conduite de telle façon que chaque unité de travail 12a à 12f exécute des cycles de travail successifs différents de ceux des autres unités, étant entendu que des opérations données en des points des plaques ayant des coordonnées en X différentes, peuvent être exécutées simultanément.

A cela s'ajoute que l'entre-axe des unités de travail peut être réduit au module standard minimal des plaques de circuit, si bien que l'usinage peut être réalisé selon des motifs dont la largeur (direction X) n'excède pas cette valeur.

Ainsi, on peut travailler avec une plus grande souplesse et augmenter les cadences de travail sans pour autant nuire à la qualité de l'usinage.

Il est à noter également que les unités de travail peuvent ne pas participer toutes en même temps à une série d'opérations d'usinage, un espace de "garage" leur étant réservé à gauche et/ou à droite de la zone de travail proprement dite de la machine.

Les cycles de changement d'outils se déroulent comme décrit dans le brevet français FR 2 532 226 précité, à ceci près que les mouvements relatifs des unités de travail 12a à 12f, des dispositifs de transfert 40a à 40f et des magasins d'outils sont réalisés différemment, le mouvement en X étant exécuté par les déplacements en X de la règle 33.

Selon un mode de réalisation de l'invention qui n'a pas été représenté aux dessins, la machine peut comporter une ou plusieurs autres rangées d'unités de travail situées derrière la rangée que l'on voit sur les figures. L'agencement d'une ou de telle(s) rangée(s) supplémentaire(s) serait le même que celui de la rangée représentée. A titre de variante, un ou toutes les rangées supplémentaires pourraient être montées sur des portiques montés mobiles sur le bâti de la machine selon la direction Y. Il est évident que dans ces conditions la rapidité d'exécution de la machine s'en trouverait augmentée considérablement au prix d'une complication de construction et de commande.

## Revendications

1. Machine-outil, notamment pour exécuter des opérations d'usinage de circuits imprimés par perçage, fraisage ou contournage, cette machine comprenant :
- un bâti,
- un porte-pièces (5) monté mobile sur ledit bâti (1) dans au moins une première direction (Y),
- des premiers moyens moteurs (9, 10, 11) destinés à déplacer le porte-pièces (5),
- au moins deux unités de travail (12a à 12f) aptes à recevoir sélectivement des outils (16) pour exécuter lesdites opérations d'usinage,
- des moyens de guidage (14a, 14b) solidaires dudit bâti (1) pour guider lesdites unités de travail (12a à 12f) dans une seconde direction (X) perpendiculaire à ladite première direction (Y),
- des moyens de coulissement (18, 19) coopérant avec lesdits moyens de guidage (14a, 14b) et portant lesdites unités de travail (12a à 12f) pour permettre de les déplacer selon ladite seconde direction (X), et
- des seconds moyens moteurs (24 à 29) couplés auxdits moyens de coulissement (18, 19) pour assurer les déplacements desdites unités de travail (12a à 12f),
cette machine-outil étant caractérisée en ce que
- lesdits moyens de coulissement comportent des unités de coulissement (18, 19) indépendantes associées à chaque unité de travail (12a à 12f) respective et en ce que
- lesdits seconds moyens moteurs (24 à 29) comportent une unité motrice et des moyens de commande de l'unité motrice (26, 27, 28) pour chaque unité de travail afin de déplacer de façon complètement indépendante chacune des unités de travail dans ladite deuxième direction.

2. Machine-outil suivant la revendication 1, caractérisée en ce que lesdits seconds moyens moteurs comprennent un organe commun de réaction fixe (24) s'étendant dans ladite seconde direction au moins sur toute la longueur de la zone de travail (ZT) de la machine dans cette direction, et en ce que l'unité motrice (26, 27, 28) de chaque unité de travail (12a à 12f) prend appui sur ledit organe de réaction (24) pour transmettre sa force motrice en vue des déplacements de l'unité dans ladite seconde direction (X) indépendemment des déplacements des autres unités.

3. Machine-outil suivant la revendication 2, caractérisée en ce que ledit organe de réaction commun est une vis sans fin (24).

4. Machine-outil suivant la revendication 2 ou 3, caractérisée en ce que l'unité motrice est un moteur électrique dont le rotor (27) est en prise avec l'organe de réaction (24) et dont le stator est fixé dans l'unité de travail (12).

5. Machine-outil suivant l'une quelconque des revendications 2 à 4, caractérisée en ce que ledit organe de réaction (24) s'étend au-delà de la ladite zone de travail (ZT) dans au moins une zone de garage (ZG) latérale pour permettre d'écarter au moins une unité de travail lorsque son emploi est temporairement suspendu pendant l'usinage.

6. Machine-outil suivant l'une quelconque des revendications précédentes, caractérisée en ce que chaque unité de travail comporte un carter (15) présentant des organes de coulissement (18, 19) s'étendant latéralement du carter (15) dans ladite seconde direction (X), le bâti de la machine présentant au moins une coulisse (14a, 14b) sur laquelle s'appuyent lesdits organes de coulissement (18, 19), et en ce que ledit carter présente des dégagements (23) à des endroits complémentaires aux organes de coulissement de manière que, lorsque deux unités de travail (12) sont rapprochés l'une de l'autre les organes de coulissement (18, 19) s'imbriquent dans les dégagements complémentaires (23) de la ou des unité(s) voisin(es).

7. Machine-outil suivant la revendication 6, caractérisée en ce que l'entre-axe minimal (EA) des unités de travail est égal ou inférieur au module normalisé de dimension des plaques de circuits intégrés.

8. Machine-outil suivant la revendication 6 ou 7, caractérisée en ce que chaque organe de coulissement (18, 19) comprend un patin (18) à coussin d'air appliqué sur la ou les coulisse(s) (14a, 14b).

9. Machine-outil suivant l'une quelconque des revendications 6 à 8, caractérisée en ce qu'elle comprend deux coulisses (14a, 14b) de section rectangulaire et s'étendant parallélement l'une à l'autre dans ladite seconde direction (X) avec un certain espacement longitudinal et en ce que le carter (15) de chaque unité de travail (12a à 12f) présente le profil d'un H vu dans ladite seconde direction, des organes de coulissement étant en appui contre trois faces longitudinales adjacentes (20a, 20b, 21a, 21b, 22a, 22b) desdites coulisses (14a, 14b).

10. Machine-outil suivant l'une quelconque des revendications précédentes, caractérisée en ce qu elle comprend un système de positionnement incrémental linéaire associé auxdites unités de travail, ce système étant équipé d'une unique règle graduée (43) portant une graduation de positionnement (43a) uniforme sur toute sa longueur, ladite règle s'étendant dans ladite seconde direction (X) et en ce que chaque unité de travail (12a à 12f) comprend un capteur de position (45) coopérant avec ladite règle.

11. Machine-outil suivant la revendication 10, caractérisée en ce que ladite règle (43) porte une deuxième graduation (43b) composée de repères (47) définissant la position de repos des unités de travail (12a à 12f).

12. Machine-outil suivant la revendication 11, caractérisée en ce que chaque repère de position de repos (47) est associé à un repère de codage représentatif du numéro d'ordre de l'unité de travail considérée dans la rangée d'unités de travail (12a à 12f).

13. Machine-outil suivant l'une quelconque des revendications 1 à 12 équipée d'un système automatique de changement d'outil qui comprend, associés à chaque unité de travail (12a à 12f), au moins un magasin porte-outils et un dispositif de transfert d'outils (40a à 40f) solidaire dudit porte-pièces (5), caractérisée en ce que les magasins (34) sont montés sur une règle de support (33) s'étendant dans ladite seconde direction (X) et fixée sur ledit bâti (1) de manière réglable dans ladite seconde direction.

14. Machine-outil suivant la revendication 13, caractérisée en ce que ladite règle (33) est également montée mobile par rapport audit bâti (1) dans une direction (Z) perpendiculaire auxdites première et seconde directions.

15. Machine-outil suivant l'une quelconque des revendications précédentes, caractérisée en ce que lesdites unités de travail sont disposées sur plusieurs rangées parallèles orientées selon ladite seconde direction (X), et, le cas échéant, montées mobiles selon ladite première direction (Y).

## Patentansprüche

1. Werkzeugmaschine, insbesondere für die Ausführung von Bearbeitungsoperationen an gedruckten Schaltkreisen mittels Bohren, Fräsen oder Konturieren, welche Maschine umfaßt:
- ein Gestell,
- einen auf dem Gestell (1) in mindestens einer ersten Richtung (Y) beweglich montierten Werkstückträger (5),
- erste Motormittel (9, 10, 11) für die Verlagerung des Werkstückträgers (5),
- mindestens zwei Arbeitseinheiten (12a bis 12f), ausgebildet zum selektiven Aufnehmen von Werkzeugen (16) für die Ausführung der Bearbeitungsoperationen,
- Führungsmittel (14a, 14b), die mit dem Gestell (1) verbunden sind für das Führen der Arbeitseinheiten (12a bis 12f) in einer zweiten, zur ersten Richtung (Y) senkrechten Richtung (X),
- Gleitmittel (18, 19), die mit den Führungsmitteln (14a, 14b) zusammenwirken und die Arbeitseinheiten (12a bis 12f) tragen, um deren Verlagerung in der zweiten Richtung (X) zu ermöglichen, und
- zweite Motormittel (24 bis 29), gekoppelt mit den Gleitmitteln (18, 19) zum Sicherstellen der Verlagerung der Arbeitseinheiten (12a bis 12f),
welche Werkzeugmaschine dadurch gekennzeichnet ist, daß
- die Gleitmittel unabhängige Gleiteinheiten (18, 19) umfassen, zugeordnet jeder jeweiligen Arbeitseinheit (12a bis 12f), und daß
- die zweiten Motormittel (24 bis 29) eine Antriebseinheit umfassen und Steuermittel für die Antriebseinheit (26, 27, 28) für jede Arbeitseinheit, um in vollständig unabhängiger Weise jede Arbeitseinheit in der zweiten Richtung zu verlagern.

2. Werkzeugmaschine nach Anspruch 1, dadurch gekennzeichnet, daß die zweiten Motormittel ein gemeinsames festes Reaktionsorgan (24) umfassen, das sich in der zweiten Richtung auf mindestens der gesamten Länge der Arbeitszone (ZT) der Maschine in dieser Richtung erstreckt, und daß die Antriebseinheit (26, 27, 28) jeder Arbeitseinheit (12a bis 12f) sich auf dem Reaktionsorgan (24) abstützt, um seine Antriebskraft für die Verlagerung der Einheit in der zweiten Richtung (X) unabhängig von Verlagerungen der anderen Einheiten zu übertragen.

3. Werkzeugmaschine nach Anspruch 2, dadurch gekennzeichnet, daß das gemeinsame Reaktionsorgan eine Schnecke (24) ist.

4. Werkzeugmaschine nach Anspruch 2 oder 3, dadurch gekennzeichnet, daß die Antriebseinheit ein Elektromotor ist, dessen Rotor (27) in Eingriff mit dem Reaktionsorgan (24) steht und dessen Stator in der Arbeitseinheit (12) festgelegt ist.

5. Werkzeugmaschine nach einem der Ansprüche 2 bis 4, dadurch gekennzeichnet, daß das Reaktionsorgan (24) sich über die Arbeitszone (ZT) in mindestens eine seitliche Ablagezone (ZG) hinauserstreckt, um das Beiseiteschaffen mindestens einer Arbeitseinheit zu ermöglichen, wenn deren Verwendung zeitweilig während der Benutzung unterbrochen ist.

6. Werkzeugmaschine nach einem der vorangehenden Ansprüche, dadurch gekennzeichnet, daß jede Arbeitseinheit ein Gehäuse (15) umfaßt, das Gleitorgane (18, 19) aufweist, welche sich seitlich vom Gehäuse (15) in die zweite Richtung (X) erstrecken, daß das Gestell der Maschine mindestens eine Kulisse (14a, 14b) umfaßt, auf der sich die Gleitorgane (18, 19) abstützen, und daß das Gehäuse Ausnehmungen (23) an Stellen aufweist, die komplementär sind zu den Gleitorganen derart, daß dann, wenn zwei Arbeitseinheiten (12) sich einander nähern, die Gleitorgane (18, 19) sich in die komplementären Ausnehmungen (23) der benachbarten Einheit(en) fügen.

7. Werkzeugmaschine nach Anspruch 6, dadurch gekennzeichnet, daß der Minimalachsabstand (EA) der Arbeitseinheiten gleich oder kleiner ist als der Standardabmessungsmodul von integrierten Schaltkreisen.

8. Werkzeugmaschine nach Anspruch 6 oder 7, dadurch gekennzeichnet, daß jedes Gleitorgan (18, 19) einen Luftkissenschuh (18) umfaßt, der an die Kulisse(n) (14a, 14b) angelegt ist.

9. Werkzeugmaschine nach einem der Ansprüche 6 bis 8, dadurch gekennzeichnet, daß sie zwei Kulissen (14a, 14b) rechteckigen Querschnitts umfaßt, die sich parallel zueinander in der zweiten Richtung (X) mit einem bestimmten Längsabstand erstrecken, und daß das Gehäuse (15) jeder Arbeitseinheit (12a bis 12f) ein H-Profil aufweist, gesehen in der zweiten Richtung, wobei die Gleitorgane in Anlage an drei benachbarten Längsseiten (20a, 20b, 21a, 21b, 22a, 22b) der Kulissen (14a, 14b) sind.

10. Werkzeugmaschine nach einem der vorangehenden Ansprüche, dadurch gekennzeichnet, daß sie ein lineares inkrementales Positionsiersystem umfaßt, zugeordnet den Arbeitseinheiten, welches System mit einem einzigen indizierten Maßstab (43) ausgestattet ist, der eine Positionierteilung (43a) trägt, welche gleichförmig auf seiner Gesamtlänge ist, welcher Maßstab sich in der zweiten Richtung (X) erstreckt, und daß jede Arbeitseinheit (12a bis 12f) einen Positionssensor (45), der mit dem Maßstab zusammenwirkt, umfaßt.

11. Werkzeugmaschine nach Anspruch 10, dadurch gekennzeichnet, daß der Maßstab (43) eine zweite Teilung (43b) trägt, zusammengestellt aus Markierungen (47), welche die Ruheposition der Arbeitseinheiten (12a bis 12f) definiert.

12. Werkzeugmaschine nach Anspruch 11, dadurch gekennzeichnet, daß jede Ruhepositionsmarkierung (47) einer Kodiermarkierung zugeordnet ist, die repräsentativ ist für die Zahl in der Reihenfolge der Arbeitseinheiten, betrachtet in der Rangfolge der Arbeitseinheiten (12a bis 12f).

13. Werkzeugmaschine nach einem der Ansprüche 1 bis 12, ausgestattet mit einem automatischen Werkzeugwechselsystem, das, jeder Arbeitseinheit (12a bis 12f) zugeordnet, mindestens ein Werkzeugträgermagazin und ein Werkzeugtransfereinrichtung (40a bis 40f) umfaßt, verbunden mit dem Werkstückträger (5), dadurch gekennzeichnet, daß die Magazine (34) auf einem Supportmaßstab (33) montiert sind, der sich in der zweiten Richtung (X) erstreckt und auf dem Gestell (1) in einer in der zweiten Richtung einstellbaren Weise befestigt ist.

14. Werkzeugmaschine nach Anspruch 13, dadurch gekennzeichnet, daß der genannte Maßstab (33) ebenfalls beweglich relativ zu dem Gestell (1) in einer Richtung (Z) senkrecht zu der ersten und der zweiten Richtung montiert ist.

15. Werkzeugmaschine nach einem der vorangehenden Ansprüche, dadurch gekennzeichnet, daß die Arbeitseinheiten in mehreren parallelen Reihen in der zweiten Richtung (X) orientiert und gegebenenfalls beweglich in der ersten Richtung (Y) montiert sind.

## Claims

1. Machine tool, in particular for machining printed circuits by drilling, milling or shaping, such machine comprising:
- a frame,
- a work table (5) mounted so as to be movable in at least a first direction (Y) on said frame (1),
- first motor means (9, 10, 11) adapted to move the work table (5),
- at least two operating units (12a to 12f) adapted to receive tools (16) selectively so as to carry out said machining operations,
- guide means (14a, 14b) integral with said frame (1) adapted to guide said operating units (12a to 12f) in a second direction (X) perpendicular to said first direction (Y),
- sliding means (18, 19) cooperating with said guide means (14a, 14b) and supporting said operating units (12a to 12f) to enable them to move in said second direction (X), and
- second motor means (24 to 29) coupled to said sliding means (18, 19) to ensure the movements of said operating units (12a to 12f),
such machine tool being characterized in that
- said sliding means comprises independent sliding units (18, 19) associated with each respective operating unit (12a to 12f) and in that
- said second motor means (24 to 29) comprises a motor unit and motor unit control means (26, 27, 28) for each operating unit whereby each of said operating unit is able to move completely independently in said second direction.

2. Machine tool according to claim 1, characterized in that said second motor means have a common fixed reaction member (24) extending in said second direction at least along the entire length of the working area (ZT) of the machine in this direction and in that the motor unit (26, 27, 28) of each operating unit (12a to 12f) contacts said reaction member (24) so as to transmit its drive force according to the movements of the unit in said second direction (X) independently of the movements of the other operating units.

3. Machine tool according to claim 2, characterized in that said common reaction member is an endless screw (24).

4. Machine tool according to claim 2 or 3, characterized in that the motor unit is an electric motor, the rotor (27) of which engages with the reaction member (24) and the stator of which is fixed in the operating unit (12).

5. Machine tool according to any one of claims 2 to 4, characterized in that said reaction member (24) extends beyond said operating area (ZT) in at least one lateral parking area (ZG) to make it possible to move aside at least one operating unit when its use is temporarily suspended during machining.

6. Machine tool according to any one of the preceding claims, characterized in that each operating unit has a housing (15) having sliding members (18, 19) extending laterally from the housing (15) along said second direction (X), the frame of the machine tool having at least one slide member (14a, 14b) on which said sliding members (18, 19) rest, and in that said housing has clearances (23) at complementary locations to the sliding members in such a manner that, when two operating units (12) are brought together, the sliding members (18, 19) overlap in complementary clearances (23) of the neighbouring unit(s).

7. Machine tool according to claim 6, characterized in that the minimal distance (EA) between the centre axes of the operating units is equal to or less than the standardized modular dimension of the integrated circuit boards.

8. Machine tool according to claim 6 or 7, characterized in that each sliding member (18, 19) comprises an air cushioned runner (18) applied to the slide(s) (14a, 14b).

9. Machine tool according to any one of claims 6 to 8, characterized in that it comprises two slides (14a, 14b) of rectangular section and extending parallel to one another in said second direction (X) with a specific longitudinal clearance and in that the casing (15) of each operating unit (12a to 12f) resembles an H profile viewed in said second direction, sliding members bearing against three adjacent longitudinal faces (20a, 20b, 21a, 21b, 22a, 22b) of said slides (14a, 14b).

10. Machine tool according to any one of the preceding claims, characterized in that it comprises an incremental linear positioning system associated with said operating units, this system being provided with a single graduated scale (43) having regular positioning markings (43a) over its entire length, said scale extending in said second direction (X) and in that each operating unit (12a to 12f) has a position meter (45) cooperating with said scale.

11. Machine tool according to claim 10, characterized in that said scale (43) has a second set of markings (43b) composed of reference markings (47) defining the rest position of the operating units (12a to 12f).

12. Machine tool according to claim 11, characterized in that each reference marking of the rest position (47) is associated with a coded reference marking representing the serial number of the operating unit considered in the line of operating units (12a to 12f).

13. Machine tool according to any one of claims 1 to 12 equipped with an automatic tool changing system which comprises, associated with each operating unit (12a to 12f), at least one tool holder magazine and one tool transfer means (40a to 40f) integral with said table (5), characterized in that the magazines (34) are mounted on a support scale (33) extending in said second direction (X) and fixed to said frame (1) in an adjustable manner in said second direction.

14. Machine tool according to claim 13, characterized in that said scale (33) is also movably mounted in relation to said frame (1) in a direction (Z) perpendicular to said first and second directions.

15. Machine tool according to any one of the preceding claims, characterized in that said operating units are arranged on several parallel rows oriented along said second direction (X) and, where that is the case, movably mounted along said first direction (Y).
